# EUROPEAN PATENT APPLICATION

(11) **EP 0 622 475 A1**
(43) Date of publication of application: **02.11.1994**
(21) Application number: 94302468.7
(22) Date of filing: 07.04.1994
(51) Int. Cl.: C23C 16/44, B01D 19/00

(54) **Method and apparatus for degassing semiconductor processing liquids**

(30) Priority: 29.04.1993 US 57042
(71) Applicant: APPLIED MATERIALS, INC., Santa Clara, California 95054-3299 (US)
(72) Inventor: Sivaramakrishnan, Visweswaren, Cupertino, CA 95014 (US); Zhao, Jun, Milpitas, CA 95035 (US)
(74) Representative: Bayliss, Geoffrey Cyril

(57) **Abstract**

The disclosure relates to a degasser for removing gas entrapped or dissolved in a semiconductor wafer processing liquid consisting of a housing (62) and a fluid inlet/outlet (22) through which the processing liquid is passed respectively into and out of the housing. The degasser includes a separator (68) in the form of a circular pipe defining a tortuous (preferably spiral) path for the processing fluid as it passes through the housing. The separator is configured to be pervious to the molecules of the entrapped or dissolved gas but impervious to the molecules of the liquid. The degasser also includes a port (66) through which the housing (62) can be evacuated thereby resulting in a pressure differential across the separator. This causes molecules of the entrapped or dissolved gas to leave the liquid and to permeate through the separator and thus removing the gas from the processing liquid.

## Description

This invention relates to semiconductor processing apparatus and operations and, more particularly, to a method and apparatus for removing gasses entrapped or dissolved in semiconductor processing liquids before such liquids are vaporized and delivered to a semiconductor processing chamber.

In semiconductor wafer processing operations, wafer processing reactant fluids are often supplied to the interior of a wafer processing chamber in a gaseous form. It is, however, common for some of these reactants to be chemical precursors which are stored at some distant storage point in liquid form. The reactants are then supplied from the liquid storage, through a flow meter to be vaporized in a vaporizer and thereafter to the chamber in gaseous form.

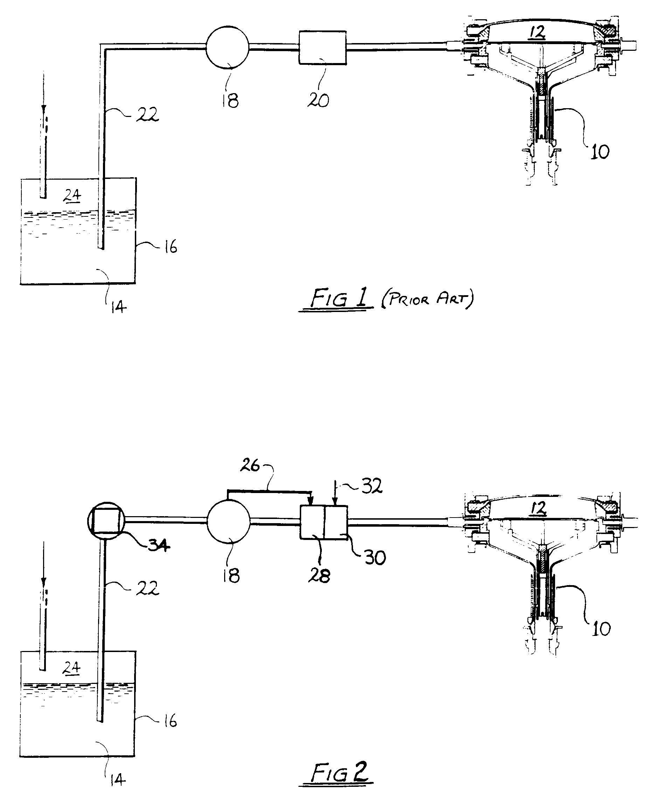

A typical example of a wafer processing system incorporating these elements is schematically illustrated in Fig. 1. In this figure a typical chemical vapor deposition (CVD) wafer processing apparatus 10 is shown to include a processing chamber 12. A standard commercial wafer processing liquid 14 is housed in a liquid form in a sealed fluid container 16. For CVD processes, the processing liquid 14 (sold under brand names such as TEOS®) contains a source of silicon and optionally a dopant liquid such as TEOP®, TMB®, TMP®, TEP® and the like. The liquid 14 is supplied to the chamber 12 via a liquid flow meter 18 and a vaporizer 20, all of which are connected together by means of a supply conduit 22. The flow meter is intended to very accurately regulate the amount of processing fluid passing into the chamber 12 and the vaporizer functions to convert the fluid 14 from its liquid to its gaseous state.

The liquid 14 is moved along the conduit 22 by injecting an inert gas such as Helium, Argon or Nitrogen under pressure into the space 24 above the surface of the liquid 14 in the container 16. As a result of the pressurizing effect of the inert gas, the fluid 14 flows under pressure along the conduit 22 and is controlled and vaporized before flowing into the chamber 12.

A problem with this type of arrangement is that the inert gas injected into the space 24 becomes entrapped or dissolved in the processing fluid 14. This is particularly so as the affinity of the processing fluid 14 for the inert gas increases as the pressure (and also the temperature and time of contact) in the container 16 increases. Consequently the processing liquid 14 flowing through the meter 18 has a certain amount of gas entrapped or dissolved in it. As the liquid flow meter 18 measures the flow of the liquid together with the entrapped or dissolved gas passing along the conduit 22, the meter 18 is unable to determine accurately the volume of processing fluid alone passing into the chamber 12. As a result of this, incorrect amounts of processing fluid can be delivered to the chamber 12. This can impair the wafer processing operations and particularly the quality of the processed wafer.

This problem is exacerbated by the fact that the container 16 is typically at a lower elevation than the liquid flow meter 18. In addition, certain friction losses occur in the supply conduit 22. Both these factors contribute to a fairly substantial pressure drop in the liquid processing fluid 14 between the container 16 and the liquid flow meter 18. As the amount of gas entrapped or dissolved in the processing fluid 14 is directly related to the pressure of the processing fluid, this drop in pressure causes some of the previously entrapped or dissolved gas to "bubble" out of the fluid and form pockets of gas in the fluid stream.

The liquid flow meter is unable to either measure or account for these pockets of gas and, as a result, inaccurate measurements occur. In certain extreme cases, these pockets of gas can block the flow of fluid flowing through the measuring portion of the flow meter 18 causing the flow meter to read a zero flow condition when in fact flow is still occurring. In the event of this type of blockage the flow meter overcompensates and an excessive amount of processing fluid is delivered to the processing chamber 12.

In the past various solutions to this problem have been attempted. Certain prior art devices have the processing fluid 14 contained in a flexible and compressible bag in the container 16. In this type of apparatus the inert gas is forced between the bag and the walls of the container 16 so that the bag is gradually compressed, forcing the fluid into the conduit 22. These types of devices have, however, been found to be unsuccessful as leaking and rupturing of the bags occur.

Another solution has been to use a piston type of arrangement to apply pressure to the fluid 14 instead of using an inert gas. Once again this type of arrangement has been found inadequate because accurate pressurization of the processing fluid 14 is very difficult using mechanical means such as this. Furthermore, this apparatus suffers from the disadvantage that leaking past the piston can occur which results in inaccurate fluid deliver and wasted processing fluid.

The need therefore exists for a different means of supplying processing fluid to a processing chamber in such a manner that the processing fluid passing through the liquid flow meter is free of entrapped or dissolved gas. Preferably such apparatus should include a means for removing any entrapped or dissolved gas from the processing fluid before it passes through the flow meter.

Briefly according to a this invention, a degasser for removing gas entrapped or dissolved in a processing liquid, comprises:
(i) a housing;
(ii) a fluid inlet and a fluid outlet through which the processing liquid is respectively passed into and out of the housing;
(iii) a separator mounted to the housing and being configured to be pervious to the molecules of the entrapped or dissolved gas but impervious to the molecules of the liquid; and
(iv) means for applying a pressure differential across the separator to cause molecules of the entrapped or dissolved gas to leave the liquid and to permeate through the separator thereby removing the entrapped or dissolved gas from the processing liquid.

Preferably the separator is housed within the housing and defines the walls of a hollow conduit along which the fluid is passed.

Typically the housing defines a sealed chamber about the conduit and includes a port through which the chamber can be evacuated to produce the pressure differential across the walls of the conduit. As the permeability of the wall of the conduit increases with increasing temperature, this invention also provides for a heater element which is located within the chamber and which serves to heat the conduit to thereby increase its permeability to the entrapped or dissolved gases.

Generally the conduit is in the form of a circular pipe which defines a tortuous, preferably spiral path through the chamber.

An advantage of this invention is that it provides for a method and apparatus for removing entrapped or dissolved gas from semiconductor wafer processing fluid before such processing fluid arrives at the means controlling the supply of such fluid to a semiconductor wafer processing apparatus. Accordingly, the supply of such processing fluid to the chamber can be more accurately controlled.

Another advantage of this invention is that the gas removal can be achieved using a relatively simple device which has a gas removal component which has no moving parts.

Yet another advantage of this invention is that the removal of the entrapped or dissolved gas improves the wafer processing operation and, accordingly, the quality of the processed wafer.

These and other advantages of the present invention will no doubt become apparent to those skilled in the art after having read the following detailed description of the preferred embodiment which is illustrated in the several figures of the drawings as follows:
Fig. 1 is a schematic representation of a semiconductor wafer processing system illustrating the problems of the prior art;
Fig. 2 is a schematic representation similar to that in Fig. 1 but illustrating the invention;
Fig.3 is a cross section through a schematic illustration of one embodiment of an apparatus, for removing entrapped or dissolved gases from a semiconductor wafer processing fluid, according to invention;
Fig. 4 is a partial cross section through another embodiment of the invention; and
Fig. 5 is a partial cross sectional, exploded view of yet another embodiment of the invention.

In Fig. 2 a wafer processing system very similar to that illustrated in Fig. 1 is shown. Components in Fig. 2 which are the same or similar to those in Fig. 1 have therefore been given the same reference numeral. Accordingly, Fig. 1 shows a wafer processing apparatus 10, including a processing chamber 12, which is supplied with processing fluid 14 from a sealed container 16. The flow of the processing fluid 14 is monitored by flow meter 18 and is achieved by injecting an inert gas such Helium, Argon or Nitrogen under pressure into the space 24 above the surface of the fluid 14 in the container 16. This, in turn, drives the processing fluid 14 along the conduit 22.

The flow meter 18 monitoring the flow of the processing fluid 14 in the conduit, is connected via connection line 26 to a fluid control valve 28. Should the flow meter 18 sense that an excessive amount of processing fluid 14 is flowing into the conduit 22 it signals the control valve 28 which, in turn, operates to restrict the flow of the fluid 14. Similarly, if the flow meter 18 senses that too little fluid is flowing in the conduit 22 it signals the control valve 28 which opens to allow additional fluid to flow into the chamber 12.

Attached to the control valve is a vaporizer 30 which operates to vaporize the processing fluid 14 as it passes through the control valve 28. In a preferred embodiment of this vaporizer 30, it is formed integrally with the control valve 28 and vaporization of the fluid 14 is achieved by reducing the pressure from between 10 to 15 psig on one side of the control valve to about 10 Torr on the downstream side of the control valve 28.

This vaporized fluid 14 is transported into the chamber 12 by means of a continuous flow of a carrier Helium gas which passes into the vaporizer 30 from a Helium inlet port 32. The details of this combined control valve 28 and vaporizer 30 are described in greater detail in EP-A-93120131.3.

The system illustrated in Fig. 2 also shows an in-line degasser 34 which is located in-line on the conduit 22 between the container 16 and the flow meter 18. Although a specific position is shown in this figure, this degasser 34 can be located at any point along the conduit 22 between the container 16 and the flow meter 18.

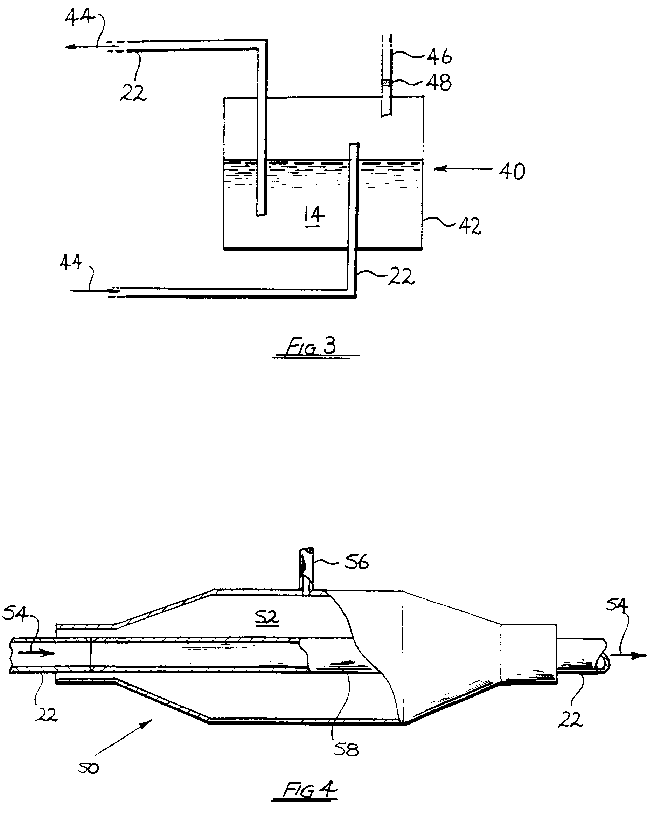

The degasser 34, different embodiments of which will be described in greater detail below with reference to Figs. 3 to 5, operates to remove any of the inert gas that has been entrapped or dissolved in the processing fluid 14. As a result of the operation of the degasser 34 the processing fluid 14 delivered by a conduit 22 to the flow meter 18 has little or no entrapped or dissolved gas therein. This means that the liquid flow meter is presented with a substantially gas-free liquid and therefore much more accurate measurement of the amount of liquid passing along conduit 22 and into the chamber 12 can be made.

One embodiment of this degasser, generally indicated as 40, is illustrated in Fig. 3. The degasser 40 is shown to include a sealed reservoir 42 which contains a supply of processing fluid 14. The fluid 14 is supplied to fill the reservoir 42 and is removed from the reservoir (once filled) along conduit 22 in the direction indicated by the arrows 44. The reservoir 42 includes a vacuum port 46 which has a membrane separator 48 located across it to prevent the uninhibited flow of matter out of the reservoir 42.

Once the reservoir is filled with fluid 14, and while the fluid passes through the reservoir 40, a vacuum is drawn (by means not shown) at the port 46 to create a pressure differential across the membrane separator 48. This reduces the pressure inside the reservoir which, in turn, because of its lower density, any gas entrapped or dissolved in the fluid 14 moves upwards in the reservoir and is drawn through the membrane separator 48. Consequently, the processing fluid 14 which is removed from the reservoir 42 has substantially less entrapped or dissolved gas than the fluid 14 entering the reservoir.

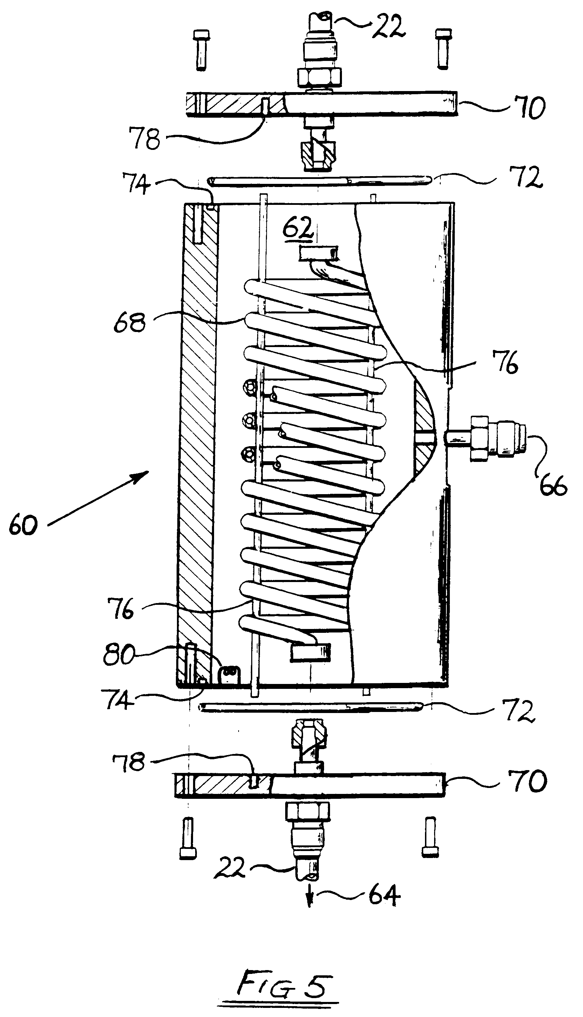

The membrane separator 48 must be chosen so that it is porous to the molecules of the inert gas that bubbles out of the processing fluid 14 but is impervious to molecules of the processing fluid 14. As a result of this and other considerations the material of the membrane separator 48 must be selected fairly carefully. These considerations and the types of materials which are appropriate for use as a separator will not be discussed here as they are dealt with below under the discussion of the embodiment shown in Fig. 5.

Another embodiment of the degasser of this invention is illustrated in Fig. 4. The degasser, generally indicated as 50, is shown to include a generally cylindrical vacuum chamber 52 through which the conduit 22 passes. The direction of the fluid along this conduit 22 in indicated by arrows 54. The wall of vacuum chamber 52 has a vacuum port 56 formed in it through which the chamber 52 can be evacuated to reduce the pressure therein. Typically the pressure in the vacuum chamber is reduced to 1 to 3 Torr.

The fluid supply conduit 22 is connected, within the body of the degasser 50, to a separator 58 in the form of a pipe, typically of similar dimensions to the fluid conduit 22. The pipe wall defining the separator is, as with the membrane separator 48 in Fig. 3, made of a material which is pervious to the molecules of the entrapped or dissolved gas but which is impervious to the molecules of the processing fluid flowing along it. The considerations relating to the material of the pipe-shaped separator 58 are, once again, discussed below with reference to Fig. 5.

In operation, the processing fluid flows through the degasser 50 by way of the pipe-shaped separator 58. At the same time a vacuum is drawn at the vacuum port 56 to reduce the pressure within the chamber 52 to a predetermined level. As a result of the pressure differential across the wall of the separator 58 (the pressure in the chamber 52 is 1 to 3 Torr and that of the fluid 14 is between 10 and 30 psig) gases that have been entrapped or dissolved in the fluid 14 are drawn out of the fluid and through the separator to be evacuated by way of the port 56. Consequently the fluid 14 at the downstream end of the degasser 50 is substantially free of entrapped or dissolved gas and the liquid flow meter is able to more accurately measure the flow of fluid 14 passing into the processing chamber 12.

A third, and preferred embodiment the degasser of this invention is shown in Fig. 5. The degasser, generally indicated as 60, includes a barrel-shaped, walled vacuum chamber 62 with the fluid conduit 22 connected at either end. Fluid flows through the degasser 60 in the direction indicated by arrows 64 and along a separator 68 constituted by a spirally formed pipe of separator material. As with the embodiment in Fig. 4 the pressure within the vacuum chamber 62 is reduced to approximately 1 to 3 Torr by evacuating the chamber through a vacuum port 66.

In addition, this figure shows that the degasser 60 includes two end plates 70 which are bolted one to either of its ends. Once these end plates 70 are bolted onto the ends of the degasser 60, a fluid impervious seal is formed between the end plates 70 and the main body of the degasser 60 by means of O-rings 72 located in O-ring grooves 74.

The spiral forming the separator 68 is supported inside the chamber 62 by four (of which only two are shown) vertical uprights 76. These uprights 76 slot into sockets 78 formed in both the end plates 70 and serve to provide both stability for the spirally formed separator 68 as well a cage about which it can be wrapped during the manufacturing process.

As with the embodiment in Fig. 4, processing fluid 14 flows through the degasser while, at the same time, the chamber 62 is evacuated at the vacuum port 66 to reduce the pressure therein. As a result of this pressure differential (which is similar to that discussed with reference to Fig. 4), the entrapped or dissolved gas molecules in the fluid 14 permeate through the separator 68 and are evacuated through the vacuum port 66. This process results in a substantially gas free processing liquid at the downstream end of the degasser 60.

It has been found that the rate of degassing (i.e. the removal of the entrapped or dissolved gas from the processing fluid 14) is a function of a number of factors. So, for example, the surface area of separator material across which the gas can flow, the temperature of the processing fluid 14, the material properties of the separator (such as crystalinity, thickness and temperature), the pressure differential across the separator and the size of the molecules of the entrapped or dissolved gas all effect the degas rate. Due to considerations such as current operating conditions and constraints inherent in currently used processing systems, certain factors such as the temperature of the processing fluid 14 and the size of the molecules of an entrapped or dissolved gas must be treated as constant and while the other factors are varied to improve the degas rate. This should, however, not be seen as detracting from this invention as it is envisaged that factors which are now considered to be constants could in future be varied to further enhance the degas rate.

It will be evident that the surface area of the membrane in the embodiment illustrated in Fig. 5 is greater than that of the embodiment illustrated in Fig. 4 which, in turn, is greater than that of the embodiment illustrated in Fig. 3. As the degas rate is proportional to the surface area of the membrane, the degasser in Fig. 5 is superior in this regard. For the embodiment illustrated in Fig. 5, the applicants have found that a pipe with an external diameter of 0.25 inches and with a wall thickness of 0.030 inches is sufficient to allow the processing fluid 14 to pass through the degasser 60. A conduit with this internal diameter has the advantage that it increases the ratio of separator surface area to the processing fluid passing through the degasser. Even so, it is envisaged that both the shape and the internal diameter of this pipe could be changed to further enhance the degas rate.

As mentioned above, another consideration is the thickness of the separator (i.e., wall thickness of the pipe). Generally, the separator must be thick enough to resist the pressure differential across it. At the same time, the degas rate increases with decreasing separator thickness. Notwithstanding these conflicting considerations it is believed that the wall thickness of approximately 0.030 inches provides a suitable compromise between these two requirements for the pipe in the degasser in Fig. 5.

The preferred material for the pipe is Teflon® and preferably FEP Teflon® although PFA or PTFE (polytetrafluoroethylene) Teflon® may also be adequate. FEP teflon has the advantage that it provides a separator which is porous enough to allow molecules of typical inert pressurizing gasses to pass through it while at the same time being impervious to the molecules of TEOS® or other commercially available reactants. FEP is also suitable as it has enough structural strength to withstand the pressure differential across it when formed as a pipe of the dimensions described above. Furthermore FEP is an industry accepted material for use in semiconductor processing operations. It has been found that FEP is of a relatively high purity and does not outgas and inject impurities into any processing environment or the processing fluid 14. This is not necessarily true of other materials which would otherwise be suitable for use as a separator in the degasser of the invention.

Fig. 5 also illustrates a low wattage heater 80 located inside the chamber 62. This heater 80 functions to raise the temperature of the membrane by a few, typically 10 degrees Celsius, and thereby enhance its permeability.

Finally, although not shown, it is envisaged that in either Fig. 4 or 5 the degasser of this invention could include a sensor to detect the failure of the separator. This failure could, for instance, occur if the separator ruptures. Such failure can be detected, for example, by placing a liquid sensor in the bottom of the vacuum chamber of the degasser to sense any liquid accumulating as a result of a ruptured membrane separator. Alternatively a pressure sensor could be placed near the vacuum port to detect any sudden changes of pressure within the vacuum chamber which would occur in the event of membrane failure.

Although the present invention has been described above in terms of specific embodiments and with respect to only semiconductor wafer processing operations, it is anticipated that other applications, alterations and modifications thereof will become apparent to those skilled in the art. It is therefore intended that the following claims be interpreted as covering all such other applications, alterations and modifications as fall within the true spirit and scope of the invention.

## Claims

1. A system for supplying processing fluid to a substrate processing apparatus, said system comprising:
(i) a reservoir for storing the processing fluid in liquid form;
(ii) a supply conduit along which processing fluid can be moved from the reservoir to the processing apparatus;
(iii) vaporizing means for converting the processing fluid from a liquid to a gaseous phase, the vaporizing means being located along the supply conduit between the reservoir and the processing apparatus;
(iv) liquid flow control means, disposed between the vaporizing means and the processing apparatus, for monitoring and controlling the flow of processing liquid along the conduit; and
(v) degassing means disposed between the liquid flow control means and the reservoir and operable to remove gas entrapped or dissolved in the processing liquid passing along the conduit.

2. A system as recited in Claim 1 wherein the degassing means includes:
(i) a housing;
(ii) a fluid inlet and a fluid outlet through which the processing liquid is respectively passed into and out of the housing;
(iii) a separator mounted to the housing and being configured to be pervious to the molecules of the entrapped or dissolved gas but impervious to the molecules of the liquid; and
(iv) means for applying a pressure differential across the separator to cause molecules of the entrapped or dissolved gas to leave the liquid and to permeate through the separator thereby removing the entrapped or dissolved gas from the processing liquid.

3. A system as recited in Claim 2, wherein the separator is housed within the housing and defines a hollow conduit along which the fluid is passed.

4. A system as recited in Claim 3, wherein the housing defines a sealed chamber about the conduit and wherein the housing includes a port through which the chamber can be evacuated to thereby produce the pressure differential across the separator whereby, when the pressure differential is produced molecules of entrapped or dissolved gas move out of the liquid and across the separator and are evacuated through the port.

5. A system as recited in Claim 3 or Claim 4, wherein the conduit is in the form of a circular pipe.

6. A system as recited in Claim 4 or Claim 5, wherein the conduit defines a tortuous path through the chamber.

7. A system as recited in Claim 6, wherein the conduit defines a spiral shaped path through the chamber.

8. A system as recited in any of Claims 3 to 7, wherein the conduit comprises a material of one of the group consisting of FEP, PFA or polytetrafluoro-ethylene Teflon®.

9. A degasser for removing gas entrapped or dissolved in a processing liquid, comprising:
(i) a housing;
(ii) a fluid inlet and a fluid outlet through which the processing liquid is respectively passed into and out of the housing;
(iii) a separator mounted to the housing and configured to be pervious to the molecules of the entrapped or dissolved gas but impervious to the molecules of the liquid; and
(iv) means for applying a pressure differential across the separator to cause molecules of the entrapped or dissolved gas to leave the liquid and to permeate through the separator thereby removing the entrapped or dissolved gas from the processing liquid.

10. A degasser as recited in Claim 9, wherein the separator is housed within the housing defines a hollow conduit along which the fluid is passed.

11. A degasser as recited in Claim 10, wherein the housing defines a sealed chamber about the conduit and wherein the housing includes a port through which the chamber can be evacuated to thereby produce the pressure differential across the whereby, when the pressure differential is produced, molecules of entrapped or dissolved gas move out of the liquid and across the separator and are evacuated through the port.

12. A degasser as recited in Claim 11, wherein the conduit is in the form of a circular pipe.

13. A degasser as recited in Claim 11 or Claim 12, wherein the conduit defines a tortuous path through the chamber.

14. A degasser as recited in Claim 13, wherein the conduit defined a spiral shaped path through the chamber.

15. A degasser as recited in any of Claims 9 to 14, wherein the conduit comprises a material of one of the group consisting of FEP, PFA or polytetrofluoro-ethylene Teflon®.

16. A method of supplying processing fluid to a substrate processing apparatus, comprising the steps of:
(i) storing the processing fluid in liquid form in a reservoir;
(ii) moving the processing fluid along a supply conduit from the reservoir to the processing apparatus;
(iii) converting the processing fluid from a liquid to a gaseous phase by means of a vaporizer located along the supply conduit between the reservoir and the processing apparatus;
(iv) monitoring and controlling the processing liquid moving along the conduit by means of a liquid flow control; and
(v) removing gas entrapped or dissolved in the processing liquid passing along the conduit at a point located between the reservoir and the liquid flow control.

17. A method as recited in Claim 16 wherein the step of removing gas includes:
(i) passing the processing liquid along a predetermined fluid path through a housing;
(ii) mounting a separator to the housing, the separator being configured to be pervious to the molecules of the entrapped or dissolved gas but impervious to the molecules of the liquid; and
(iii) applying a pressure differential across the separator to cause molecules of the entrapped or dissolved gas to leave the liquid and to permeate through the separator thereby removing the entrapped or dissolved gas from the processing liquid.

18. A method as recited in Claim 17, further comprising the steps of:
(i) using the housing to define a sealed chamber about the conduit, the housing including a port through which the chamber can be evacuated; and
(ii) evacuating the chamber through the port to produce the pressure differential across the separator and thereby cause molecules of entrapped or dissolved gas to move out of the liquid and across the separator and be evacuated through the port.

19. A method as recited in Claim 18, wherein the fluid path along which the fluid is passed defines a tortuous path through the chamber.
